(19) Europäisches Patentamt
European Patent Office
Office européen des brevets

(11) **EP 4 593 549 A1**

(12) **EUROPEAN PATENT APPLICATION**

(43) Date of publication:
**30.07.2025 Bulletin 2025/31**

(21) Application number: **25151903.9**

(22) Date of filing: **15.01.2025**

(51) International Patent Classification (IPC):
*H10B 51/30* (2023.01)    *H10B 51/10* (2023.01)
*H10B 51/20* (2023.01)    *H10D 30/67* (2025.01)
*H10D 99/00* (2025.01)    *H10D 30/01* (2025.01)
*H10D 30/69* (2025.01)    *H10D 64/68* (2025.01)

(52) Cooperative Patent Classification (CPC):
H10B 51/30; H10B 51/10; H10B 51/20;
H10D 30/0415; H10D 30/6739; H10D 30/6748;
H10D 30/6755; H10D 30/6757; H10D 30/701;
H10D 64/689; H10D 99/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2024 KR 20240011729
22.04.2024 KR 20240053543**

(71) Applicant: **Samsung Electronics Co., Ltd.
Suwon-si, Gyeonggi-do 16677 (KR)**

(72) Inventors:
• **YOO, Sijung
16678 Suwon-si (KR)**

• **KIM, Donghoon
16678 Suwon-si (KR)**
• **KIM, Sangwook
16678 Suwon-si (KR)**
• **NAM, Seunggeol
16678 Suwon-si (KR)**
• **YANG, Jeeeun
16678 Suwon-si (KR)**
• **CHOE, Dukhyun
16678 Suwon-si (KR)**

(74) Representative: **Elkington and Fife LLP
Prospect House
8 Pembroke Road
Sevenoaks, Kent TN13 1XR (GB)**

(54) **FERROELECTRIC FIELD EFFECT TRANSISTOR, MEMORY DEVICE, AND NEURAL NETWORK DEVICE**

(57) A ferroelectric field effect transistor (100a) includes a channel layer (103), a gate electrode (101) facing the channel layer, a ferroelectric layer (102) between the channel layer and the gate electrode, a channel intermediate layer (104) between the channel layer and the ferroelectric layer; and a gate intermediate layer (107) between the gate electrode and the ferroelectric layer, wherein the channel layer and the channel intermediate layer each include an oxide semiconductor material, a concentration of oxygen vacancies in the channel intermediate layer is greater than a concentration of oxygen vacancies in the channel layer, the gate intermediate layer comprises amorphous silicon oxynitride, and a concentration of nitrogen in the amorphous silicon oxynitride gate intermediate layer increases from the surface of the gate intermediate layer facing the gate electrode toward the surface of the gate intermediate layer facing the ferroelectric layer.

FIG. 6

**Description**

FIELD OF THE INVENTION

The disclosure relates to a ferroelectric field effect transistor, a memory device, and a neural network device.

BACKGROUND OF THE INVENTION

Ferroelectrics are materials that have ferroelectricity, and therefore maintain spontaneous polarization by aligning internal electric dipole moments even when no electric field is applied from an external electric field source. More specifically, even when a certain voltage is applied to a ferroelectric and the voltage is returned to 0 V, polarization remains semi-permanent in the ferroelectric. Research on applying these ferroelectric properties to logic devices and/or memory devices is ongoing. For example, in the case of a ferroelectric field effect transistor using a ferroelectric, the threshold voltage of the field effect transistor may vary depending on the direction and intensity of the polarization in the ferroelectric. Logic devices and/or memory devices may be implemented using threshold voltage variation characteristics of such ferroelectric field effect transistors.

SUMMARY OF THE INVENTION

Provided is a ferroelectric field effect transistor including an oxide semiconductor channel and having an improved memory window.

In addition, provided are a memory device and a neural network device, each including a diffusion barrier layer.

Additional aspects will be set forth in part in the description which follows and, in part, will be apparent from the description, or may be learned by practice of the presented embodiments of the disclosure.

According to an aspect of at least one embodiment, a ferroelectric field effect transistor includes a channel layer, a gate electrode facing the channel layer, a ferroelectric layer between the channel layer and the gate electrode, and a channel intermediate layer between the channel layer and the ferroelectric layer, wherein the channel layer and the channel intermediate layer each include an oxide semiconductor material, and a concentration of oxygen vacancies in the channel intermediate layer may be greater than a concentration of oxygen vacancies in the channel layer.

The oxide semiconductor material of the channel intermediate layer may have a stoichiometrically oxygen-deficient composition.

A thickness of the channel intermediate layer may be less than a thickness of the channel layer.

For example, a sum of the thickness of the channel layer and the thickness of the channel intermediate layer may be within a range of about 10 nm to about 20 nm, and the thickness of the channel intermediate layer may be within a range of about 1 nm to about 5 nm.

The channel layer may include a first surface and a second surface facing each other, and the ferroelectric field effect transistor may further include a source electrode and a drain electrode spaced apart from each other on the first surface of the channel layer.

The gate electrode may face the second surface of the channel layer.

The gate electrode may face the first surface of the channel layer, the channel intermediate layer may be between the source electrode and the drain electrode on the first surface of the channel layer, the source electrode may face and be spaced apart from a first side surface of the channel intermediate layer, and the drain electrode may face and be spaced apart from a second side surface opposite to the first side surface of the channel intermediate layer.

A thickness of the gate intermediate layer may be within a range of about 1 nm to about 5 nm.

The ferroelectric field effect transistor further includes a gate intermediate layer between the gate electrode and the ferroelectric layer, and the gate intermediate layer may include at least one amorphous dielectric material from among silicon oxide, silicon nitride, aluminum oxide, and silicon oxynitride.

The gate intermediate layer may include amorphous silicon oxynitride, the gate intermediate layer may include a first surface facing the gate electrode and a second surface facing the ferroelectric layer, and a concentration of nitrogen in the gate intermediate layer may increase from the first surface toward the second surface.

A concentration of oxygen in the gate intermediate layer may decrease from the first surface toward the second surface.

A concentration of oxygen on the first surface of the gate intermediate layer may be greater at a ratio of 10 % or more compared to a concentration of oxygen on the second surface of the gate intermediate layer.

A concentration of nitrogen on the second surface of the gate intermediate layer may be greater at a ratio of 10 % or more compared to a concentration of nitrogen on the first surface of the gate intermediate layer.

The concentration of silicon in the gate intermediate layer may gradually increase from the first surface toward the second surface, and the concentration of silicon on the second surface of the gate intermediate layer may be greater at a ratio of 10 % or more compared to the concentration of silicon on the first surface of the gate intermediate layer.

A ratio of the silicon concentration to the nitrogen concentration on the first surface of the gate intermediate layer may be same as a ratio of the silicon concentration to the nitrogen concentration on the second surface of the gate intermediate layer.

The gate intermediate layer may include a first gate intermediate layer facing the ferroelectric layer and a second gate intermediate layer between the first gate intermediate layer and the gate electrode, the first gate intermediate layer may include at least one of amorphous silicon nitride or amorphous silicon oxynitride, and the second gate intermediate layer may include amorphous silicon oxide.

The first gate intermediate layer may include amorphous silicon oxynitride, the first gate intermediate layer may include a first surface adjacent to the gate electrode and a second surface adjacent to the ferroelectric layer, and a concentration of nitrogen in the first gate intermediate layer may increase from the first surface toward the second surface.

A concentration of oxygen in the first gate intermediate layer may decrease from the first surface toward the second surface.

A concentration of oxygen on the first surface of the first gate intermediate layer may be greater at a ratio of 10% or more compared to a concentration of oxygen on the second surface of the first gate intermediate layer, and a concentration of nitrogen on the second surface of the first gate intermediate layer may be greater at a ratio of 10% or more compared to a concentration of nitrogen on the first surface of the first gate intermediate layer.

The concentration of silicon in the first gate intermediate layer increases from the first surface toward the second surface, and a ratio of the silicon concentration to the nitrogen concentration on the first surface of the first gate intermediate layer may be same as a ratio of the silicon concentration to the nitrogen concentration on the second surface of the first gate intermediate layer.

According to an aspect of at least one embodiment, a memory device includes a plurality of gate electrodes and a plurality of spacers alternately stacked with each other in a first direction, a channel layer extending in the first direction and spaced apart from the plurality of gate electrodes and the plurality of spacers in a second direction perpendicular to the first direction, a ferroelectric layer extending in the first direction and between the channel layer and the plurality of gate electrodes, and a channel intermediate layer between the ferroelectric layer and the channel layer, wherein the channel layer and the channel intermediate layer each include an oxide semiconductor material, and a concentration of oxygen vacancies in the channel intermediate layer may be greater than a concentration of oxygen vacancies in the channel layer.

According to an aspect of at least one embodiment, a neural network device includes an array of synapse devices, each of which includes an access transistor and a ferroelectric field effect transistor, wherein the ferroelectric field effect transistor includes a channel layer, a gate electrode facing the channel layer, a ferroelectric layer between the channel layer and the gate electrode, and a channel intermediate layer between the channel layer and the ferroelectric layer, and a concentration of oxygen vacancies in the channel intermediate layer may be greater than a concentration of oxygen vacancies in the channel layer.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view schematically showing a structure of a ferroelectric field effect transistor according to at least one embodiment;

FIG. 2 is a graph showing a result of measuring oxygen vacancies in a partial region between a channel layer and a ferroelectric layer of the ferroelectric field effect transistor shown in FIG. 1;

FIG. 3 is a graph showing a concentration distribution of oxygen vacancies in a channel intermediate layer and a channel layer of the ferroelectric field effect transistor;

FIG. 4 is a graph schematically showing polarization characteristics of the ferroelectric layer according to the concentration of oxygen vacancies in the channel intermediate layer;

FIG. 5 is a graph schematically showing a change in a memory window of the ferroelectric field effect transistor according to the concentration of oxygen vacancies in the channel intermediate layer;

FIG. 6 is a cross-sectional view schematically showing a structure of a ferroelectric field effect transistor according to at least one embodiment;

FIG. 7 is a graph showing an oxygen concentration gradient and a nitrogen concentration gradient in a gate intermediate layer of a ferroelectric field effect transistor;

FIG. 8 is a cross-sectional view schematically showing a structure of a ferroelectric field effect transistor according to at least one embodiment;

FIG. 9 is a cross-sectional view schematically showing a structure of a ferroelectric field effect transistor according to at least one embodiment;

FIG. 10 is a cross-sectional view schematically showing a structure of a ferroelectric field effect transistor according to at least one embodiment;

FIG. 11 is a cross-sectional view schematically showing a structure of a ferroelectric field effect transistor according to at least one embodiment;

FIG. 12 is a cross-sectional view schematically showing a structure of a ferroelectric field effect transistor according to at least one embodiment;

FIGS. 13 and 14 are horizontal and vertical cross-sectional views schematically showing a structure of a memory cell string of a memory device according to at least one embodiment, respectively;

FIG. 15 is a cross-sectional view schematically illustrating a structure of a memory cell string of a memory device, according to at least one embodiment;

FIG. 16 is a cross-sectional view schematically illustrating a structure of a memory cell string of a memory device, according to at least one embodiment;

FIG. 17 is a diagram illustrating an equivalent circuit of a memory device according to at least one embodiment;

FIG. 18 is a schematic circuit diagram of a neural network device according to at least one embodiment; and

FIG. 19 is a schematic block diagram showing an example configuration of an electronic device including a neural network device.

## DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a ferroelectric field effect transistor, a memory device, and a neural network device will be described with reference to detail with reference to the accompanying drawings. In the following drawings, the same reference numerals refer to the same components, and the size of each component in the drawings may be exaggerated for clarity and convenience of description. In addition, the embodiments described below are merely examples and various modifications are possible from these embodiments. Additionally, when the terms "about" or "substantially" are used in this specification in connection with a numerical value and/or geometric terms, it is intended that the associated numerical value includes a manufacturing tolerance (e.g., $\pm 10\%$) around the stated numerical value. Further, regardless of whether numerical values and/or geometric terms are modified as "about" or "substantially," it will be understood that these values should be construed as including a manufacturing or operational tolerance (e.g., $\pm 10\%$) around the stated numerical values and/or geometry. Additionally, whenever a range of values is enumerated, the range includes all values within the range as if recorded explicitly clearly, and may further include the boundaries of the range. Accordingly, the range of "X" to "Y" includes all values between X and Y, including X and Y.

Hereinafter, terms "upper" or "top" or "lower" or "bottom" may include not only those directly above/below/left/-right in contact, but also those above/below/left/right without contact. It will also be understood that such spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The singular expression includes plural expressions unless the context clearly implies otherwise. In addition, when a part "includes" a component, this means that it may further include other components, not excluding other components unless otherwise stated.

The use of the term "the" and similar indicative terms may correspond to both singular and plural. If there is no explicit description or contrary description of the order of the steps or operations constituting the method, these steps or operations may be carried out in an appropriate order and are not necessarily limited to the described order.

Further, the terms like "units" which denote functional elements that process at least one function or operation, may be realized by processing circuitry such as, hardware, software, or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC), a programmable logic unit, a microprocessor, or an application-specific integrated circuit (ASIC), etc.

The connection or connection members of lines between the components shown in the drawings exemplarily represent functional connection and/or physical or circuit connections, and may be replaceable or represented as various additional functional connections, physical connections, or circuit connections in an actual device.

The use of all examples or exemplary terms is merely for describing a technical idea in detail and the scope is not limited to the examples or exemplary terms unless limited by the claims.

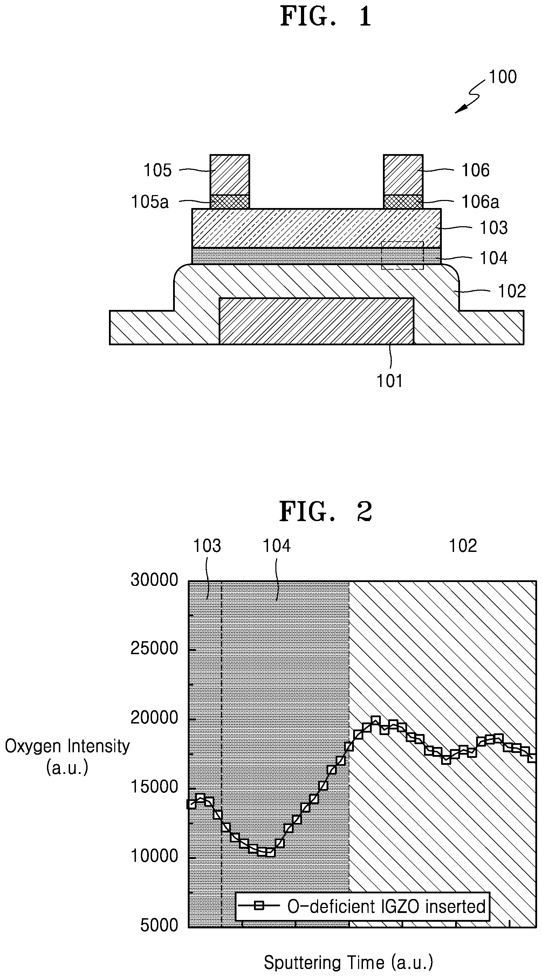

FIG. 1 is a cross-sectional view schematically showing a structure of a ferroelectric field effect transistor according to at least one embodiment. Referring to FIG. 1, a ferroelectric field effect transistor 100 includes a gate electrode 101, a ferroelectric layer 102 surrounding both side surfaces and an upper surface of the gate electrode 101, a channel intermediate layer 104 provided on an upper surface of the ferroelectric layer 102, a channel layer 103 provided on an upper surface of the channel intermediate layer 104, a source electrode 105 provided on an upper surface of the channel layer 103, and a drain electrode 106 on the upper surface of the channel layer 103 and spaced apart from the source electrode 105.

The ferroelectric field effect transistor 100 shown in FIG. 1 may be referred to as having a lower gate structure. In other words, the gate electrode 101 may be provided on the lower side of the ferroelectric field effect transistor 100, and the channel layer 103 may be provided on the upper side of the gate electrode 101 to face the gate electrode 101. The ferroelectric layer 102 may be provided between the gate electrode 101 and the channel layer 103. The channel intermediate layer 104 may be provided between the ferroelectric layer 102 and the channel layer 103. The source electrode 105 and the drain electrode 106 may be opposite to the gate electrode 101 with respect to the channel layer 103. For example, the source electrode 105 and the drain electrode 106 may be provided on the upper side of the channel layer 103, and the gate electrode 101 may be provided on the lower side of the channel layer 103. In other words, the channel layer 103 includes a first surface and a second surface facing each other, the source electrode 105 and the drain electrode 106 may be provided on the first surface of the channel layer 103, and the gate electrode 101 may be provided facing the second surface of the channel layer 103.

The ferroelectric field effect transistor 100 may also optionally further include a first contact layer 105a between the source electrode 105 and the channel layer 103 and a second contact layer 106a between the drain electrode 106 and the channel layer 103. The first contact layer 105a and the second contact layer 106a may serve to lower contact resistance between the source electrode 105 and the channel layer 103 and contact resistance between the drain electrode 106 and the channel layer 103, respectively. Each of the first contact layer 105a and the second contact layer 106a may include, for example, indium tin oxide (ITO).

In at least some embodiments, the gate electrode 101 may have conductance of approximately 1 Mohm/square or less. The gate electrode 101 may include, for example, a conductive material, such as metals, metal nitrides, metal carbides, polysilicon, combinations thereof, and/or the like. For example, the metals may include at least one of aluminum (Al), tungsten (W), molybdenum (Mo), titanium (Ti), and/or tantalum (Ta), the metal nitrides may include at least one of titanium nitride (TiN) and/or tantalum nitride (TaN), and the metal carbides may include at least one of aluminum and/or silicon doped (or containing) metal carbides (for example, TiAlC, TaAlC, TiSiC, TaSiC, etc.).

The gate electrode 101 may be a single layer structure or a multi-layer structure. For example, the gate electrode 101 may have a structure in which a plurality of materials are stacked. For example, the gate electrode 101 may have a laminated structure of a metal nitride layer/metal layer such as TiN/Al or a laminated structure of a metal nitride layer/metal carbide layer/metal layer such as TiN/TiAlC/W. The gate electrode 101 may include a titanium nitride (TiN) layer or molybdenum (Mo), and the example may be used in various modifications.

In addition, in at least some embodiments, the gate electrode 101 may include a conductive two-dimensional material. For example, the conductive two-dimensional material may include at least one of graphene, black phosphorus, amorphous boron nitride, two-dimensional hexagonal boron nitride (h-BN), and phosphorene.

The ferroelectric layer 102 may include a ferroelectric material. Ferroelectrics are materials with ferroelectricity that maintain spontaneous polarization by aligning internal electric dipole moments without an electric field being applied from an external electric field source. The threshold voltage of the ferroelectric field effect transistor 100 according to the embodiment may change depending on a polarization direction of the ferroelectric layer 102, for example, a direction from the gate electrode 101 toward the channel layer 103 or vice versa.

The ferroelectric layer 102 may include, for example, a ferroelectric having at least one of a fluorite structure, a perovskite structure, and/or a wurtzite structure. In at least some embodiments, the ferroelectric may include a crystal structure including a crystal phase lacking an inversion center (e.g., is non-centrosymmetric). The ferroelectric having a fluoride structure may include, for example, hafnium oxide ($HfO_2$). In at least some embodiments, the hafnium oxide may be doped with at least one element of zirconium (Zr), lanthanum (La), aluminum (Al), silicon (Si), yttrium (Y), and gadolinium (Gd). Alternatively, the ferroelectric layer 102 may include hafnium and zirconium in substantially the same element ratio (e.g., $Hf_{0.5}Zr_{0.5}O_2$), and additionally, at least one element among lanthanum (La), aluminum (Al), silicon (Si), yttrium (Y), and gadolinium (Gd) may be doped at a ratio of less than about 10 at%. In addition, the ferroelectric having a perovskite structure may include, for example, lead zirconate titanate (PZT). The ferroelectric having a wurtzite structure may include, for example, zinc oxide (ZnO) and/or aluminum nitride (AlN). The ferroelectric of such a wurtzite structure may be doped with, for example, at least one element of boron (B) and scandium (Sc). The thickness of the ferroelectric layer 102 may be, for example, about 5 nm to about 20 nm.

The ferroelectric layer 102 may further include an antiferroelectric material. For example, the antiferroelectric material may include zirconium oxide. For example, the zirconium oxide may be doped with at least one element of hafnium (Hf), lanthanum (La), aluminum (Al), silicon (Si), yttrium (Y), and/or gadolinium (Gd).

The channel layer 103 may include an oxide semiconductor material. The oxide semiconductor material may include an oxide of at least one metal of indium (In), gallium (Ga), zinc (Zn), tungsten (W), tin (Sn), and/or the like. For example, the channel layer 103 may include at least one oxide semiconductor material from among indium-gallium-zinc oxide (IGZO), indium-zinc oxide (IZO), gallium-zinc oxide (GZO), zinc oxide (ZnO), zinc-tin oxide (ZTO), indium tungsten oxide (IWO), $In_2O_3$, $Ga_2O_3$, $SnO_2$, and $WO_3$. In addition, the channel layer 103 may include an oxide semiconductor material further doped with at least one metal from among aluminum (Al), cadmium (Cd), copper (Cu), silicon (Si), zirconium (Zr), magnesium (Mg), hafnium (Hf), and/or the like. In addition to the above-described materials, the channel layer 103 may include various other oxide semiconductor materials such as $INb_2O_5$, TiSrOs, and the like.

Since the ferroelectric field effect transistor 100 according to the embodiment uses an oxide semiconductor material as the channel layer 103, the ferroelectric field effect transistor 100 may have relatively low leakage current characteristics in an off state and may have a relatively fast operation speed due to high electron mobility of the oxide semiconductor material. In addition, since an insulating interface layer (which may cause unnecessary parasitic capacitance) is not naturally generated on the surface of the oxide semiconductor material, a memory window, which is a difference between two different threshold voltages of the ferroelectric field effect transistor 100, may increase.

Meanwhile, within the channel layer 103 containing the oxide semiconductor material described above, there may be almost no minority carriers due to the high bandgap of the oxide semiconductor material. For example, there may be almost no p-charge carriers (e.g., holes) in the channel layer 103. For this reason, when the channel layer 103 and the ferroelectric layer 102 are in direct contact with each other, the ferroelectric layer 102 may have polarization in only one direction. For example, even if a voltage higher than a coercive voltage is applied to the gate electrode 101 of the ferroelectric field effect transistor 100, polarization switching hardly occurs in the ferroelectric layer 102, and only the intensity of polarization may change. Therefore, when the channel layer 103 and the ferroelectric layer 102 come into direct contact with each other, the memory window of the ferroelectric field effect transistor 100 may be reduced.

According to at least one embodiment, a channel intermediate layer 104 is provided between the ferroelectric layer 102 and the channel layer 103 to enable polarization switching of the ferroelectric layer 102. Like the channel layer 103, the channel intermediate layer 104 includes an oxide semiconductor material and may have a higher concentration of oxygen vacancies than the channel layer 103. The channel intermediate layer 104 having a relatively high concentration of oxygen vacancies may increase the amount of depletion charge having a positive charge value in a depletion region. Therefore, since the ferroelectric layer 102 is in direct contact with the channel intermediate layer 104 between the ferroelectric layer 102 and the channel layer 103 and/or since the ferroelectric layer 102 is positioned closer to the channel intermediate layer 104 than the channel layer 103, the ferroelectric layer 102 may switch polarization in both directions. As a result, the memory window of the ferroelectric field effect transistor 100 may be further increased.

The channel intermediate layer 104 may include an oxide semiconductor material including an oxide of at least one metal from among indium (In), gallium (Ga), zinc (Zn), tungsten (W), tin (Sn), and/or the like. The channel intermediate layer 104 and the channel layer 103 may include the same oxide semiconductor material, but may include different oxide semiconductor materials. For example, both the channel layer 103 and the channel intermediate layer 104 may include IGZO, or the channel layer 103 may include IGZO and the channel intermediate layer 104 may include IZO.

The channel layer 103 and the channel intermediate layer 104 may form a channel together. However, if the thickness of the channel intermediate layer 104 is too large, the threshold voltage of the ferroelectric field effect transistor 100 may be shifted in a negative (-) direction, resulting in deterioration of leakage current characteristics in an off state. Therefore, the thickness of the channel intermediate layer 104 may be less than the thickness of the channel layer 103. For example, the sum of the thickness of the channel layer 103 and the thickness of the channel intermediate layer 104 may be about 10 nm to about 20 nm, and the thickness of the channel intermediate layer 104 may be about 1 nm to about 5 nm.

In addition, the channel intermediate layer 104 may be placed opposite the source electrode 105 and the drain electrode 106 with respect to the channel layer 103. For example, the source electrode 105 and the drain electrode 106 may be provided above the upper side of the channel layer 103, and the channel intermediate layer 104 may be provided on the lower side of the channel layer 103. Since the ferroelectric layer 102 is provided on the lower side of the channel intermediate layer 104, the ferroelectric layer 102 may not be in direct contact with the channel layer 103.

FIG. 2 is a graph showing a result of measuring oxygen vacancies in a partial region between a channel layer 103 and a ferroelectric layer 102 of the ferroelectric field effect transistor 100 shown in FIG. 1. For example, the oxygen components in the channel layer 103, channel intermediate layer 104, and ferroelectric layer 102 were detected using X-ray photoelectron spectroscopy (XPS) for a rectangular region indicated by a dotted line in FIG. 1. Referring to FIG. 2, the amount of oxygen in the channel intermediate layer 104 is greatly reduced. Therefore, it may be seen that the concentration of oxygen vacancies in the channel intermediate layer 104 increases.

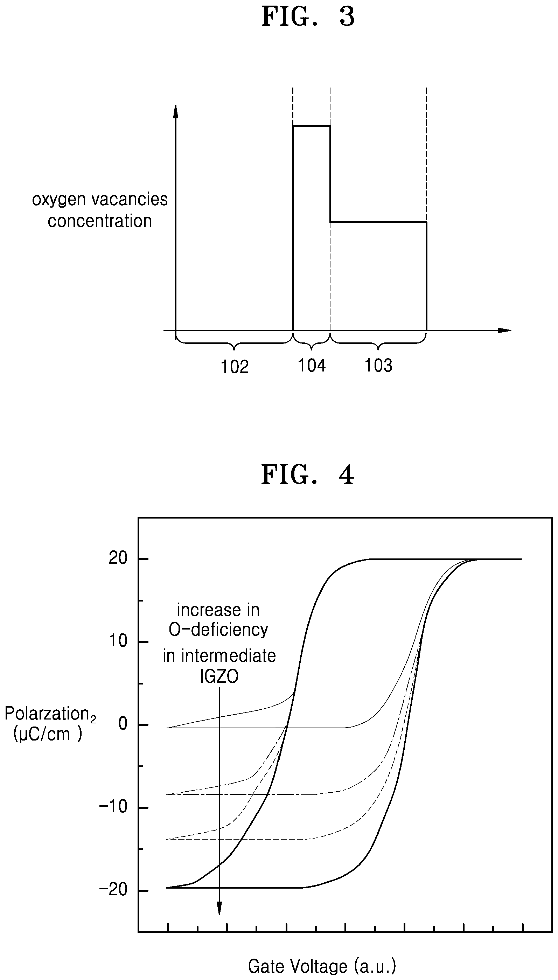

FIG. 3 is a graph showing the concentration distribution of oxygen vacancies in the channel intermediate layer 104 and the channel layer 103 of the ferroelectric field effect transistor 100. Referring to FIG. 3, a concentration of oxygen vacancies in the channel intermediate layer 104 may be higher than a concentration of oxygen vacancies in the channel layer 103. For example, the concentration of oxygen vacancies in the channel intermediate layer 104 may be about 1.2 times or more, about 1.5 times or more, or about twice as high as the concentration of oxygen vacancies in the channel layer 103.

Oxygen vacancies in the channel intermediate layer 104 may be formed by deficiently supplying an oxygen material in the process of forming the channel intermediate layer 104. For example, the channel intermediate layer 104 may be formed by sputtering, atomic layer deposition (ALD), chemical vapor deposition (CVD), and/or the like. In the process of depositing the oxide semiconductor material of the channel intermediate layer 104, oxygen vacancies may be formed in the channel intermediate layer 104 by supplying oxygen into the chamber in a stoichiometrically deficient manner, and the concentration of the oxygen vacancies may be adjusted according to the amount of oxygen provided in the chamber. Therefore, the oxide semiconductor material of the channel intermediate layer 104 may have a stoichiometrically oxygen-deficient composition.

FIG. 4 is a graph schematically showing polarization characteristics of the ferroelectric layer 102 according to the concentration of oxygen vacancies in the channel intermediate layer 104. Referring to FIG. 4, the polarization direction and the polarization intensity of the ferroelectric layer 102 may vary according to the voltage applied to the gate electrode 101 of the ferroelectric field effect transistor 100. When there are not enough oxygen vacancies in the channel intermediate layer 104, for example, when the concentration of oxygen vacancies in the channel intermediate layer 104 is approximately the same as the concentration of oxygen vacancies in the channel layer 103, the polarization of the ferroelectric layer 102 changes only between 0 (zero) and positive (+) values. In other words, the polarization of the ferroelectric layer 102 has only one direction, and polarization switching does not occur in both directions. If the concentration of oxygen vacancies in the channel intermediate layer 104 is sufficiently high, polarization switching may occur in both directions in the ferroelectric layer 102. In other words, the polarization of the ferroelectric layer 102 may vary between a negative (-) value and a positive (+) value. As the concentration of oxygen vacancies in the channel intermediate layer 104 increases, an absolute value of the negative maximum value of polarization of the ferroelectric layer 102 may increase.

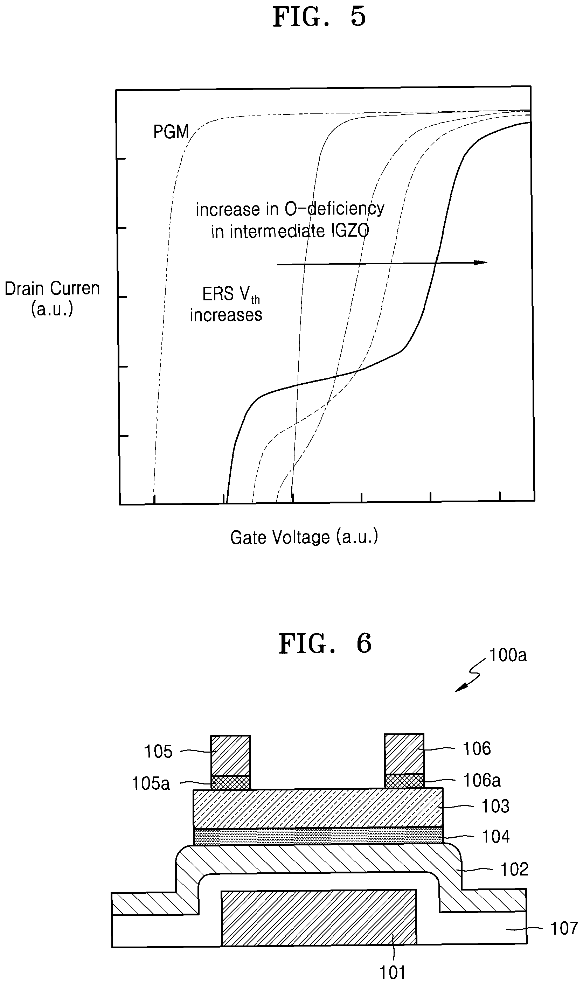

FIG. 5 is a graph schematically showing a change in a memory window of the ferroelectric field effect transistor 100 according to concentration of oxygen vacancies in the channel intermediate layer 104. The ferroelectric field effect transistor 100 may have a first threshold voltage which is relatively low and a second threshold voltage which is relatively high, according to the direction and intensity of polarization in the ferroelectric layer 102. The threshold voltage of the ferroelectric field effect transistor 100 may be a voltage when the current flowing between the source electrode 105 and the drain electrode 106 is saturated while gradually increasing the gate voltage applied to the gate electrode 101. When the ferroelectric field effect transistor 100 has the first threshold voltage, it may be called a "program (PGM)" state, and when the ferroelectric field effect transistor 100 has the second threshold voltage, it may be called an "erase (ERS)" state. The first threshold voltage may be constant regardless of the concentration of oxygen vacancies in the channel intermediate layer 104. On the contrary, as the concentration of oxygen vacancies in the channel intermediate layer 104 increases, the second threshold voltage may increase. Accordingly, as the concentration of oxygen vacancies in the channel intermediate layer 104 increases, a memory window, which is a difference between the first threshold voltage and the second threshold voltage, may increase.

FIG. 6 is a cross-sectional view schematically showing a structure of a ferroelectric field effect transistor according to at least one embodiment. Referring to FIG. 6, a ferroelectric field effect transistor 100a may further include a gate intermediate layer 107 provided between the gate electrode 101 and the ferroelectric layer 102. The configuration of the ferroelectric field effect transistor 100a except for the gate intermediate layer 107 is the same as (or substantially similar to) that of the ferroelectric field effect transistor 100 shown in FIG. 1, and thus, the detailed description thereof is omitted.

The memory window (MW) of the ferroelectric field effect transistor 100a may be expressed by Equation 1 below.

[Equation 1]

$$MW = \frac{\Delta P - \Delta Q_{it}}{C_{FE}} + \frac{\Delta Q'_{it} - \Delta Q_{it}}{C_{TD}}$$

In Equation 1 above, $\Delta P$ is the polarization amount or polarization intensity of the ferroelectric layer 102, $\Delta Q_{it}$ is the amount of charge trapped at the interface of the ferroelectric layer 102 facing the channel layer 103, $\Delta Q'_{it}$ is the amount of charge trapped at the interface of the ferroelectric layer 102 facing the gate electrode 101, $C_{FE}$ is the capacitance of the ferroelectric layer 102, and $C_{TD}$ is the capacitance between the ferroelectric layer 102 and the gate electrode 101.

As may be seen from Equation 1 above, as the capacitance between the ferroelectric layer 102 and the gate electrode 101 decreases, the memory window MW of the ferroelectric field effect transistor 100a may increase. The gate intermediate layer 107 may be provided to further increase the memory window MW of the ferroelectric field effect transistor 100a by lowering the capacitance between the ferroelectric layer 102 and the gate electrode 101. To this end, the gate intermediate layer 107 may include a dielectric material having a relatively low dielectric constant. For example, the gate intermediate layer 107 may include at least one amorphous dielectric material from among silicon oxide (SiO), silicon nitride (SiN), aluminum oxide (AlO), and silicon oxynitride (SiON). The thickness of the gate intermediate layer 107 may be about 1 nm to 5 nm, and/or about 3 nm to about 5 nm.

When the gate intermediate layer 107 includes amorphous silicon oxynitride (SiON), the gate intermediate layer 107 may further increase the memory window by increasing the amount $\Delta Q'_{it}$ of charges trapped at the interface of the ferroelectric layer 102 facing the gate electrode 101. In addition, the gate intermediate layer 107 including amorphous silicon oxynitride (SiON) may prevent or minimize the deterioration of surrounding layers by preventing or reducing the diffusion of oxygen. To this end, the concentration of oxygen in the gate intermediate layer 107 may gradually decrease (e.g., not stepwise) as it approaches the ferroelectric layer 102 and gradually increase as it approaches the gate electrode 101. In contrast to oxygen, the concentrations of nitrogen and silicon within the gate intermediate layer 107 may gradually increase as it approaches the ferroelectric layer 102 and gradually decrease as it approaches the gate electrode 101. Therefore, the concentration gradient of oxygen and the concentration gradients of nitrogen and silicon may appear oppositely in the gate intermediate layer 107. In other words, the gate intermediate layer 107 includes a first surface adjacent to the gate electrode 101 and a second surface adjacent to the ferroelectric layer 102, and the concentration of oxygen in the gate intermediate layer 107 may gradually decrease from the first surface toward the second surface, and the concentrations of nitrogen and silicon may gradually increase from the first surface toward the second surface.

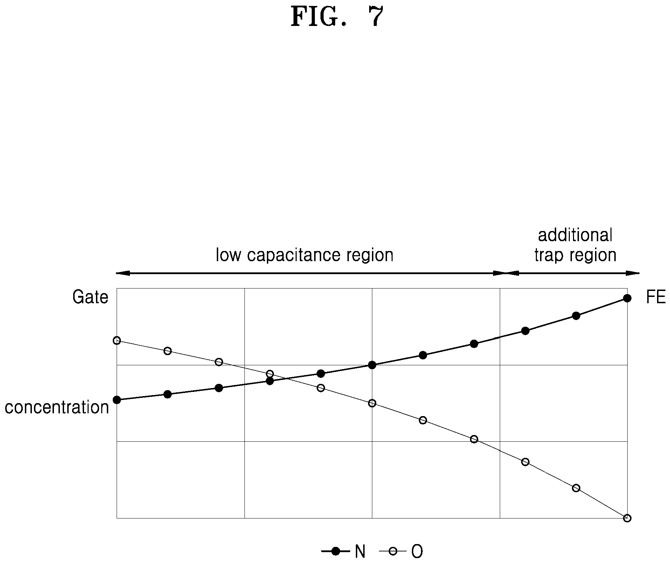

FIG. 7 is a graph showing an oxygen concentration gradient and a nitrogen concentration gradient in a gate intermediate layer 107 of a ferroelectric field effect transistor 100a. In the graph of FIG. 7, the horizontal axis indicates the distance from the lower surface (or first surface) of the gate intermediate layer 107 facing the gate electrode 101 toward the upper surface (or second surface) of the gate intermediate layer 107 facing the ferroelectric layer 102, and the vertical axis indicates the concentrations of oxygen and nitrogen in the gate intermediate layer 107. As shown in FIG. 7, the gate intermediate layer 107 may have an oxygen concentration gradient that gradually decreases from the first surface toward the second surface. In other words, the oxygen concentration may be the highest on the first surface of the gate intermediate layer 107 adjacent to the gate electrode 101, and the oxygen concentration may gradually decrease toward the second surface of the gate intermediate layer 107 adjacent to the ferroelectric layer 102, so that the oxygen concentration may be the lowest on the second surface of the gate intermediate layer 107.

For example, compared to the oxygen concentration on the second surface of the gate intermediate layer 107, the oxygen concentration on the first surface of the gate intermediate layer 107 may be higher at a rate of about 10 % or more, about 50 % or more, about 100 % or more, and/or about 300 % or more. The difference between the oxygen concentration on the first surface of the gate intermediate layer 107 and the oxygen concentration on the second surface of the gate intermediate layer 107 may be about 5 at% or more, about 10 at% or more, and/or about 20 at% or more. If the difference in oxygen concentrations between the first surface and the second surface of the gate intermediate layer 107 is about 5 at% or more, oxygen may be sufficiently prevented or reduced from passing through the gate intermediate layer 107, so that a maximum difference in oxygen concentrations between the upper and lower portions of the gate intermediate layer 107 does not need to be limited. However, considering the amount of oxygen that can be bonded to the gate intermediate layer 107, the difference between the oxygen concentration on the first surface of the gate intermediate layer 107 and the oxygen concentration on the second surface of the gate intermediate layer 107 may be about 60 at% or less.

In addition, the concentration of silicon (Si) and the concentration of nitrogen (N) may change according to the change in the concentration of oxygen in the gate intermediate layer 107. Referring to FIG. 7, the gate intermediate layer 107 may have a nitrogen concentration gradient that gradually increases from the first surface toward the second surface. In other words, the nitrogen concentration may be the lowest on the first surface of the gate intermediate layer 107, and the nitrogen concentration may gradually increase toward the second surface of the gate intermediate layer 107, so that the nitrogen concentration may be the maximum on the second surface of the gate intermediate layer 107. For example, compared to the nitrogen concentration on the first surface of the gate intermediate layer 107, the nitrogen concentration on the second surface of the gate intermediate layer 107 may be higher at a rate of about 10% or more, about 20% or more, about 50% or more, and/or about 100% or more. The difference between the nitrogen concentration on the second surface of the gate intermediate layer 107 and the nitrogen concentration on the first surface of the gate intermediate layer 107 may be about 5 at% or more, about 10 at% or more, and/or about 20 at% to about 60 at%.

Although not shown in FIG. 7, like nitrogen, the silicon concentration may be the lowest on the first surface of the gate intermediate layer 107, and the silicon concentration may gradually increase toward the second surface of the gate intermediate layer 107, so that the silicon concentration may be the maximum on the second surface of the gate intermediate layer 107. For example, compared to the silicon concentration on the first surface of the gate intermediate layer 107, the silicon concentration on the second surface of the gate intermediate layer 107 may be higher at a rate of about 10% or more, about 20% or more, about 50% or more, and/or about 100% or more. The difference between the silicon concentration on the second surface of the gate intermediate layer 107 and the silicon concentration on the first surface of the gate intermediate layer 107 may be about 5 at% or more, about 10 at% or more, and/or about 20 at% to about 60 at%.

A ratio of the silicon concentration to the nitrogen concentration in the gate intermediate layer 107 may be constant. In other words, the ratio of the silicon concentration to the nitrogen concentration may not change within all regions of the gate intermediate layer 107. Therefore, the ratio of the silicon concentration to the nitrogen concentration on the first surface of the gate intermediate layer 107 may be the same as the ratio of the silicon concentration to the nitrogen concentration on the second surface of the gate intermediate layer 107. Here, the term "the same" does not mean "the perfectly identical", and if the deviation of the ratio of the silicon concentration to the nitrogen concentration on the first and second surfaces of the gate intermediate layer 107 is within about 5 %, both parts may be considered the same.

According to the concentration gradients of elements inside the gate intermediate layer 107, the dielectric constant of the gate intermediate layer 107 may decrease due to the high oxygen concentration toward the first surface of the gate intermediate layer 107 far away from the ferroelectric layer 102, and thus the capacitance may decrease. In addition, the charge trap may increase due to the high nitrogen concentration toward the second surface of the gate intermediate layer 107 close to the ferroelectric layer 102. Therefore, a charge trap may be additionally formed in a region close to the interface with the ferroelectric layer 102, and a memory window may be further increased. In addition, oxygen and nitrogen may exist in excess of silicon in stoichiometry in the gate intermediate layer 107. Then, defects such as oxygen vacancies or nitrogen vacancies may hardly exist inside the gate intermediate layer 107.

The memory window of the ferroelectric field effect transistor 100a shown in FIG. 6 may increase as the thickness of the gate intermediate layer 107 increases, and may increase as the pulse width of a driving voltage (e.g., a program voltage or an erase voltage) increases. According to at least one embodiment, even when the thickness of the gate intermediate layer 107 is 3 nm and the pulse width of the driving voltage is 1 $\mu$s which is relatively narrow, a relatively large memory window of about 10 V or more may be secured.

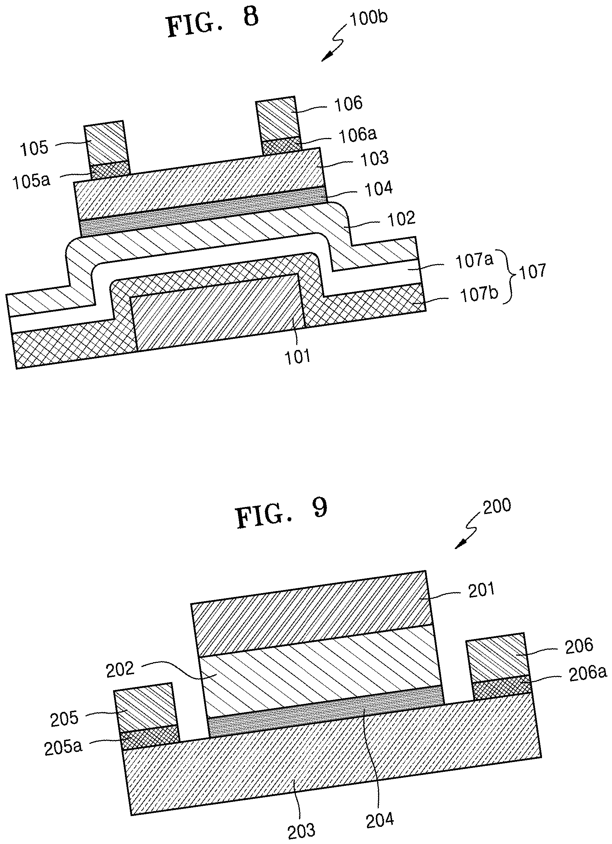

FIG. 8 is a cross-sectional view schematically showing a structure of a ferroelectric field effect transistor according to at least one embodiment. Referring to FIG. 8, in a ferroelectric field effect transistor 100b according to at least one embodiment, a gate intermediate layer 107 may have a multi-layered structure. For example, the gate intermediate layer 107 may include a first gate intermediate layer 107a in contact with the ferroelectric layer 102 and a second gate intermediate layer 107b in contact with the gate electrode 101. The first gate intermediate layer 107a may prevent or minimize deterioration of surrounding layers by preventing or reducing diffusion of oxygen. The second gate intermediate layer 107b may serve to provide low capacitance. For example, the first gate intermediate layer 107a may include amorphous silicon nitride (SiN) and/or amorphous silicon oxynitride (SiON). The second gate intermediate layer 107b may include amorphous silicon oxide (SiO) having a low dielectric constant.

When the first gate intermediate layer 107a includes amorphous silicon oxynitride (SiON), as described with reference to FIG. 7, the concentration of oxygen in the first gate intermediate layer 107a may decrease as it approaches the ferroelectric layer 102 and increase as it approaches the gate electrode 101, and the concentrations of nitrogen and silicon may increase as it approaches the ferroelectric layer 102 and decrease as it approaches the gate electrode 101. In other words, the first gate intermediate layer 107a includes a first surface adjacent to the gate electrode 101 and a second surface adjacent to the ferroelectric layer 102, and the concentration of oxygen in the first gate intermediate layer 107a may gradually decrease from the first surface toward the second surface, and the concentrations of nitrogen and silicon may gradually increase from the first surface toward the second surface. Then, the first gate intermediate layer 107a may increase the amount of electric charges trapped at the interface of the ferroelectric layer 102 to further increase the memory window. Although the lower gate structure in which the gate electrode 101 is provided below has been described so far, the ferroelectric field effect transistor according to the embodiments does not need to be limited to the lower gate structure, and may have an upper gate structure in which the gate electrode is provided above.

FIG. 9 is a cross-sectional view schematically showing a structure of a ferroelectric field effect transistor according to at least one embodiment. Referring to FIG. 9, a ferroelectric field effect transistor 200 may include a channel layer 203, a channel intermediate layer 204 provided on an upper surface of the channel layer 203, a ferroelectric layer 202 provided on an upper surface of the channel intermediate layer 204, a gate electrode 201 provided on an upper surface of the ferroelectric layer 202, and a source electrode 205 and a drain electrode 206 provided facing opposite sides of the channel intermediate layer 204 on the upper surface of the channel layer 203. The ferroelectric field effect transistor 200 may also optionally further include a first contact layer 205a between the source electrode 205 and the channel layer 203 and a second contact layer 206a between the drain electrode 206 and the channel layer 203, as needed. Since the materials, compositions, and functions of the layers shown in FIG. 9 are the same as the materials, compositions, and functions of the layers described with reference to FIG. 1, the detailed descriptions thereof are omitted, and differences are mainly described below.

The ferroelectric field effect transistor 200 shown in FIG. 9 may be referred to as having an upper gate structure. In other words, the gate electrode 201 is provided on the upper side of the ferroelectric field effect transistor 200. The gate electrode 201 may be provided on the upper side of the channel layer 203 to face the channel layer 203. The ferroelectric layer 202 may be provided between the upper surface of the channel layer 203 and the lower surface of the gate electrode 201. The channel intermediate layer 204 may be provided between the upper surface of the channel layer 203 and the lower surface of the ferroelectric layer 202.

The source electrode 205 and the drain electrode 206 may be provided on the same side as the gate electrode 201 with respect to the channel layer 203. In other words, the source electrode 205 and the drain electrode 206 may also be provided on the upper surface (e.g., the first surface) of the channel layer 203 like the gate electrode 201. The channel intermediate layer 204 may be provided between the source electrode 205 and the drain electrode 206 on the upper surface of the channel layer 203. The source electrode 205 and the drain electrode 206 may not be in direct contact with the channel intermediate layer 204. The source electrode 205 may be provided to face and be spaced apart from a first side surface of the channel intermediate layer 204. The drain electrode 206 may face and be spaced apart from the second side surface opposite to the first side surface of the channel intermediate layer 204.

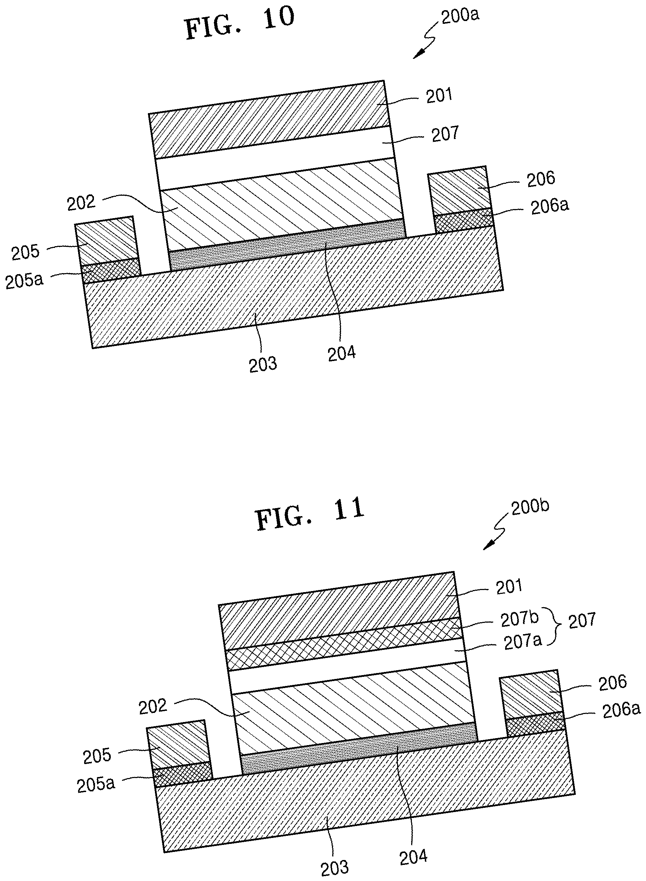

FIG. 10 is a cross-sectional view schematically showing a structure of a ferroelectric field effect transistor according to at least one embodiment. Referring to FIG. 10, a ferroelectric field effect transistor 200a may further include a gate intermediate layer 207 provided between a gate electrode 201 and a ferroelectric layer 202. The gate intermediate layer 207 may otherwise be the same as and/or substantially similar to the gate intermediate layer 107 described with reference to FIG. 6. For example, the gate intermediate layer 207 may include at least one amorphous dielectric material from among silicon oxide (SiO), silicon nitride (SiN), aluminum oxide (AlO), and silicon oxynitride (SiON). When the gate intermediate layer 207 includes amorphous silicon oxynitride (SiON), the concentration of oxygen in the gate intermediate layer 207 decreases as it gets closer to the ferroelectric layer 202 and increases as it gets closer to the gate electrode 201, and the concentrations of nitrogen and silicon may increase as it gets closer to the ferroelectric layer 202 and decrease as it gets closer to the gate electrode 201.

FIG. 11 is a cross-sectional view schematically showing a structure of a ferroelectric field effect transistor according to at least one embodiment. Referring to FIG. 11, in a ferroelectric field effect transistor 200b according to at least one embodiment, a gate intermediate layer 207 may have a multi-layered structure. For example, the gate intermediate layer 207 may include a first gate intermediate layer 207a in contact with the ferroelectric layer 202 and a second gate intermediate layer 207b in contact with the gate electrode 201. The first gate intermediate layer 207a may otherwise be the same as and/or substantially similar to the first gate intermediate layer 107a described with reference to FIG. 8, and the second gate intermediate layer 207b may otherwise be the same as and/or substantially similar to the second gate intermediate layer 107b described with reference to FIG. 8. For example, the first gate intermediate layer 207a may include amorphous silicon nitride (SiN) or amorphous silicon oxynitride (SiON), and the second gate intermediate layer 207b may include amorphous silicon oxide (SiO) having a low dielectric constant. When the first gate intermediate layer 207a includes amorphous silicon oxynitride (SiON), the concentration of oxygen in the first gate intermediate layer 207a decreases as it gets closer to the ferroelectric layer 202 and increases as it gets closer to the gate electrode 201, and the concentrations of nitrogen and silicon may increase as it gets closer to the ferroelectric layer 202 and decrease as it gets closer to the gate electrode 201. In other words, the first gate intermediate layer 207a includes a first surface adjacent to the gate electrode 201 and a second surface adjacent to the ferroelectric layer 202, and the concentration of oxygen in the first gate intermediate layer 207a may gradually decrease from the first surface toward the second surface, and the concentrations of nitrogen and silicon may gradually increase from the first surface toward the second surface.

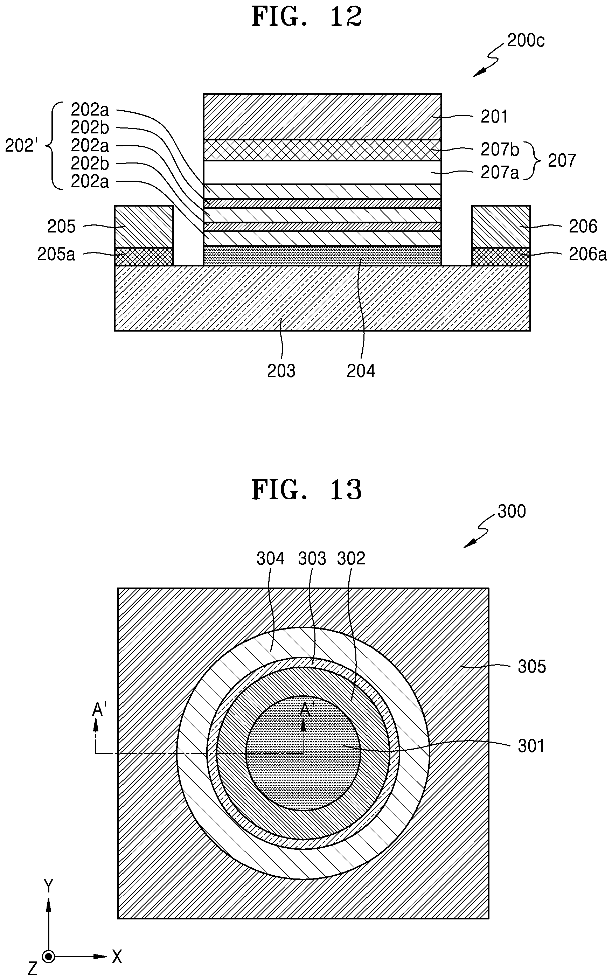

FIG. 12 is a cross-sectional view schematically showing a structure of a ferroelectric field effect transistor according to at least one embodiment. Referring to FIG. 12, a ferroelectric layer 202' of a ferroelectric field effect transistor 200c according to at least one embodiment may include a plurality of first material layers 202a and at least one second material layer 202b between two first material layers 202a facing each other. Although three first material layers 202a and two second material layers 202b are illustrated in FIG. 12, the numbers of the first material layers 202a and the second material layers 202b are not limited thereto. For example, the ferroelectric layer 202' may include two first material layers 202a and one second material layer 202b, or the ferroelectric layer 202' may include four first material layers 202a and three second material layers 202b. The remaining configuration of the ferroelectric field effect transistor 200c shown in FIG. 12 except for the ferroelectric layer 202' may be the same as the configuration of the ferroelectric field effect transistor 200b described above.

The first material layer 202a may include the same (and/or a substantially similar) ferroelectric of the ferroelectric layer 202 described with reference to FIG. 1. For example, the first material layer 202a may include a ferroelectric having at least one of the fluorite structure, the perovskite structure, and/or the wurtzite structure described above. The second material layer 202b may include a paraelectric material. For example, the second material layer 202b may include at least one paraelectric of $Al_2O_3$, $SiO_2$, $La_2O_3$, and $Y_2O_3$. In at least some embodiments, the second material layer 202b may be selected to stabilize the crystalline structure of the first material layer 202a.

In the case of the above-described ferroelectric material, when the thickness is about 10 nm or more, ferroelectric characteristics may begin to gradually deteriorate as the thickness increases. Accordingly, it is difficult to form the ferroelectric layer 102 or 202 into a single layer having a thickness of about 20 nm or more. As shown in FIG. 12, by stacking the plurality of first material layers 202a including a ferroelectric material, the ferroelectric layer 202' may be formed to have an effective thickness of 20 nm or more without degrading ferroelectric properties. The thickness of each of the first material layers 202a may be, for example, about 5 nm to about 10 nm. In addition, the thickness of the second material layer 202b may be small enough not to deteriorate the ferroelectric characteristics of the ferroelectric layer 202'. For example, the thickness of the second material layer 202b may be about 0.1 nm to about 1 nm.

Until now, the ferroelectric field effect transistor having a horizontal planar channel has been described, but the embodiments described above may also be applied to a memory device having a vertical negative-AND (VNAND) structure which is a three-dimensional (or vertical) NAND.

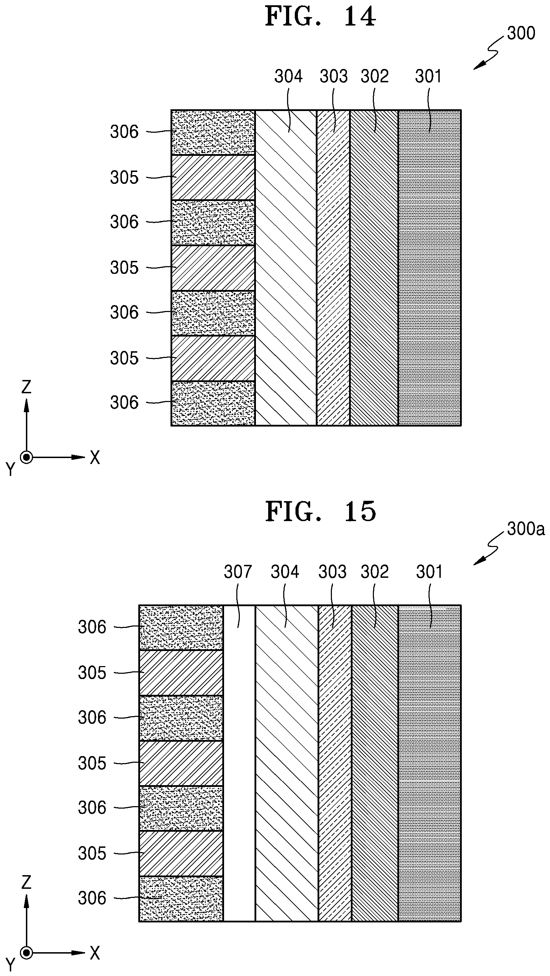

FIGS. 13 and 14 are horizontal and vertical cross-sectional views schematically showing a structure of a memory cell string of a memory device according to at least one embodiment, respectively. Referring to FIG. 13, a memory cell string 300 of a memory device according to at least one embodiment may include a central filling material 301, a channel layer 302, a channel intermediate layer 303, a ferroelectric layer 304, and a gate electrode 305 concentrically provided on an XY plane. For example, the channel layer 302 may be provided to surround the central filling material 301, the channel intermediate layer 303 may be provided to surround the channel layer 302, the ferroelectric layer 304 may be provided to surround the channel intermediate layer 303, and the gate electrode 305 may be provided to surround the ferroelectric layer 304. The central filling material 301 may serve to physically support the channel layer 302 and the memory cell string 300 by filling a space on the inner wall side of the channel layer 302. However, the central filling material 301 is not an essential component and may be omitted. In this case, an empty space may exist instead of the central filling material 301.

FIG. 14 schematically shows a structure of a memory cell string 300 taken in a first direction (e.g., the Z-axis direction) from the center of the central filling material 301 to the gate electrode 305 along the line A-A' in FIG. 13. Referring to FIG. 14, the memory cell string 300 includes: a plurality of gate electrodes 305 and a plurality of spacers 306 alternately provided in the first direction; a channel layer 302 that faces and is spaced apart from the plurality of gate electrodes 305 and the plurality of spacers 306 in a second direction (e.g., the X-axis direction) perpendicular to the first direction and continuously extends in the first direction; a ferroelectric layer 304 that continuously extends in the first direction and provided between the channel layer 302 and the plurality of gate electrodes 305; and a channel intermediate layer 303 continuously extending in the first direction and provided between the ferroelectric layer 304 and the channel layer 302. In addition, the memory cell string 300 may further include a central filling material 301 continuously extending in the first direction inside the channel layer 302. In other words, the ferroelectric layer 304, the channel intermediate layer 303, the channel layer 302, and the central filling material 301 may be sequentially provided in the second direction from the plurality of gate electrodes 305 and the plurality of spacers 306.

Each of the plurality of spacers 306 may include silicon oxide ($SiO_2$) having insulating properties, but is not limited thereto. The ferroelectric layer 304 may include the same (and/or a substantially similar) ferroelectric as the ferroelectric layer 102 described with reference to FIG. 1, the channel layer 302 may include the same (and/or a substantially similar) oxide semiconductor material as the channel layer 103 described with reference to FIG. 1, and the channel intermediate layer 303 may include the same oxide semiconductor material as the channel intermediate layer 104 described with reference to FIG. 1. In addition, the channel intermediate layer 303 may include oxygen vacancies of a high concentration, which is the same as the channel intermediate layer 104 described with reference to FIG. 1. A concentration of oxygen vacancies in the channel intermediate layer 303 may be higher than a concentration of oxygen vacancies in the channel layer 302. For example, the concentration of oxygen vacancies in the channel intermediate layer 303 may be about 1.2 times or more, about 1.5 times or more, or about twice as high as the concentration of oxygen vacancies in the channel layer 302.

FIG. 15 is a cross-sectional view schematically illustrating a structure of a memory cell string of a memory device, according to at least one embodiment. Referring to FIG. 15, a memory cell string 300a may further include a gate intermediate layer 307 continuously extending in a first direction and provided between a ferroelectric layer 304 and a plurality of gate electrodes 305 and a plurality of spacers 306 which are alternately provided in the first direction. Since the configuration of the memory cell string 300a excluding the gate intermediate layer 307 is the same as the configuration of the memory cell string 300 shown in FIGS. 13 and 14, a detailed description thereof is omitted.

The gate intermediate layer 307 may be the same as (and/or a substantially similar to) the gate intermediate layer 107 described with reference to FIG. 6. For example, the gate intermediate layer 307 may include at least one amorphous dielectric material from among silicon oxide (SiO), silicon nitride (SiN), aluminum oxide (AlO), and silicon oxynitride (SiON). In addition, when the gate intermediate layer 307 includes amorphous silicon oxynitride (SiON), the concentration of oxygen in the gate intermediate layer 307 decreases as it gets closer to the ferroelectric layer 304 and increases as it gets closer to the gate electrode 305, and the concentrations of nitrogen and silicon may increase as it gets closer to the ferroelectric layer 304 and decrease as it gets closer to the gate electrode 305. In other words, the gate intermediate layer 307 includes a first surface adjacent to the gate electrode 305 and a second surface adjacent to the ferroelectric layer 304, and the concentration of oxygen in the gate intermediate layer 307 may gradually decrease from the first surface toward the second surface, and the concentrations of nitrogen and silicon may gradually increase from the first surface toward the second surface.

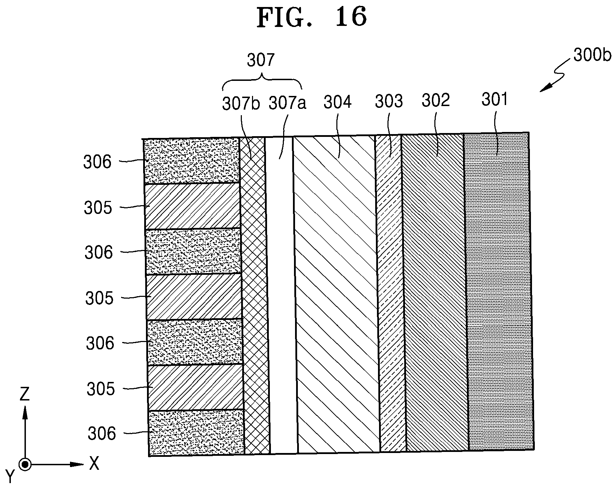

FIG. 16 is a cross-sectional view schematically illustrating a structure of a memory cell string of a memory device, according to at least one embodiment. Referring to FIG. 16, in the memory cell string 300b according to at least one embodiment, the gate intermediate layer 307 may have a multi-layered structure. For example, the gate intermediate layer 307 may include a first gate intermediate layer 307a in contact with the ferroelectric layer 304 and a second gate intermediate layer 307b in contact with the gate electrode 305. The first gate intermediate layer 307a may be the same as (and/or a substantially similar to) the first gate intermediate layer 107a described with reference to FIG. 8, and the second gate intermediate layer 307b may be the same as (and/or a substantially similar to) the second gate intermediate layer 107b described with reference to FIG. 8. For example, the first gate intermediate layer 307a may include amorphous silicon nitride (SiN) or amorphous silicon oxynitride (SiON), and the second gate intermediate layer 307b may include amorphous silicon oxide (SiO) having a low dielectric constant. When the first gate intermediate layer 307a includes amorphous silicon oxynitride (SiON), the concentration of oxygen in the first gate intermediate layer 307a decreases as it gets closer to the ferroelectric layer 304 and increases as it gets closer to the gate electrode 305, and the concentrations of nitrogen and silicon may increase as it gets closer to the ferroelectric layer 304 and decrease as it gets closer to the gate electrode 305. In other words, the first gate intermediate layer 307a includes a first surface adjacent to the gate electrode 305 and a second surface adjacent to the ferroelectric layer 304, and the concentration of oxygen in the first gate intermediate layer 307a may gradually decrease from the first surface toward the second surface, and the concentrations of nitrogen and silicon may gradually increase from the first surface toward the second surface.

In the memory cell strings 300, 300a, and 300b illustrated in FIGS. 13 to 16, one gate electrode 305, and the gate intermediate layer 307, the ferroelectric layer 304, the channel intermediate layer 303, and the channel layer 302, which are adjacent to the gate electrode 305 in the second direction may form one memory cell. In this matter, it may be considered that the memory cell strings 300, 300a, and 300b include a plurality of memory cells stacked in the first direction. In addition, a memory device having a VNAND structure may include the plurality of memory cell strings 300, 300a, and 300b provided in two dimensions.

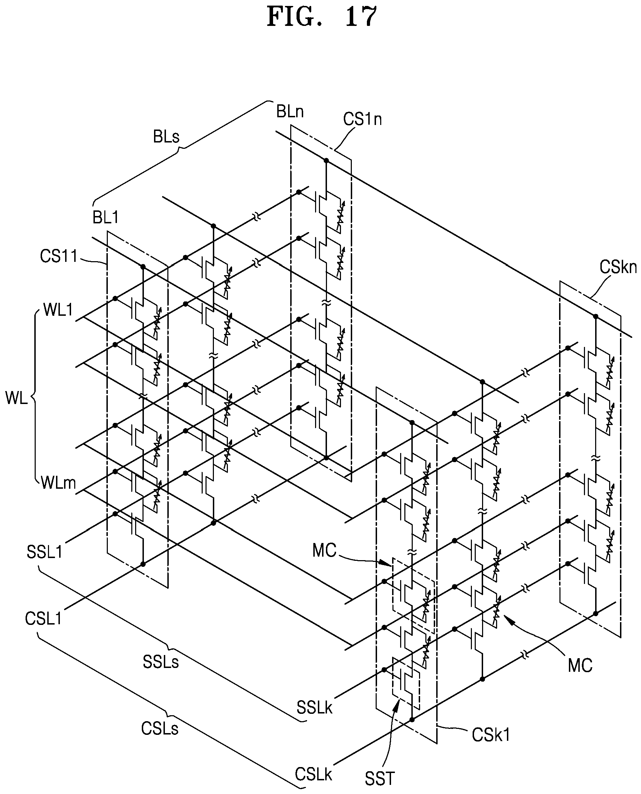

FIG. 17 is a diagram illustrating an equivalent circuit of a memory device according to at least one embodiment. Referring to FIG. 17, the memory device may include a plurality of memory cell strings CS11 to CSkn. The plurality of memory cell strings CS11 to CSkn may be two-dimensionally provided in a row direction and a column direction, thereby forming rows and columns. Each of the memory cell strings CS11 to CSkn may include a plurality of memory cells MC and a plurality of string selection transistors SST. The memory cells MC and the string selection transistors SST of each of the memory cell strings CS11 to CSkn may be stacked in a height direction. Each of the memory cells MC in each of the memory cell strings CS11 to CSkn may correspond to a circuit in which a transistor and a resistor are connected in parallel. For example, each of the memory cell strings CS11 to CSkn may be one of the memory cell strings 300, 300a, and 300b illustrated in FIGS. 13 to 16.

Rows of the plurality of memory cell strings CS11 to CSkn may be connected to a plurality of string selection lines SSL1 through SSLk, respectively. For example, the string selection transistors SST of the memory cell strings CS11 to CS1n may be commonly connected to the string selection line SSL1. The string selection transistors SST of the memory cell strings CSk1 to CSkn may be commonly connected to the string selection line SSLk.

In addition, columns of the plurality of memory cell strings CS11 to CSkn may be connected to the plurality of bit lines BL1 through BLn, respectively. For example, the memory cells MC and the string selection transistors SST of the memory cell strings CS11 to CSk1 may be commonly connected to the bit line BL1, and the memory cells MC and the string selection transistors SST of the memory cell strings CS1n to CSkn may be commonly connected to the bit line BLn.

In addition, the rows of the plurality of memory cell strings CS11 to CSkn may be connected to the plurality of common source lines CSL1 to CSLk, respectively. For example, the string selection transistors SST of the plurality of memory cell strings CS11 to CS1n may be commonly connected to the common source line CSL1, and the string selection transistors SST of the plurality of memory cell strings CSk1 to CSkn may be commonly connected to the common source line CSLk.

The memory cells MC located at the same height from a substrate (or the string selection transistors SST) may be commonly connected to one word line WL, and the memory cells MC located at different heights from the substrate (or the string selection transistors SST) may be connected to the plurality of word lines WL1 through WLm, respectively.

In such a structure, writing and reading may be performed in units of rows of memory cell strings CS11 to CSkn. For example, the memory cell strings CS11 to CSkn may be selected for each row by the common source lines CSL, and the memory cell strings CS11 to CSkn may be selected for each row by the string selection lines SSLs. In addition, the writing and reading operations may be performed for each page, in a selected row of the memory cell strings CS11 to CSkn. For example, the page may be one row of the memory cells MC connected to one word line WL. In the selected row of the memory cell strings CS11 to CSkn, the memory cells MC may be selected for each page by the word lines WL. Each of the memory cells MC may include any one of the ferroelectric field effect transistors described with reference to FIGS. 1 to 12, and/or each of the memory cell strings CS11 to CSkn may include any one of the memory cell strings described with reference to FIGS. 13-16.

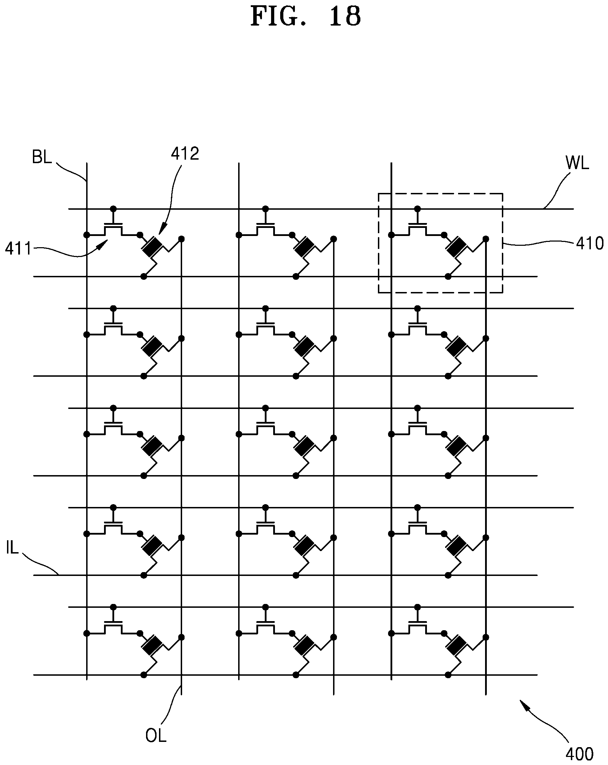

FIG. 18 is a schematic circuit diagram of a neural network device according to at least one embodiment. Referring to FIG. 18, a neural network device 400 according to at least one embodiment may include an array of a plurality of synapse devices 410 provided in two dimensions. Each of the plurality of synapse devices 410 may include an access transistor 411 and a ferroelectric field effect transistor 412. The ferroelectric field effect transistor 412 may be any one of the ferroelectric field effect transistors described with reference to FIGS. 1 to 12. The access transistor 411 may serve as a selection element for turning on/off the synapse devices 410.

The neural network device 400 may also include a plurality of word lines WL, a plurality of bit lines BL, a plurality of input lines IL, and a plurality of output lines OL. The gate of the access transistor 411 may be electrically connected to any one of the plurality of word lines WL, the source thereof may be electrically connected to any one of the plurality of bit lines BL, and the drain thereof may be connected to the gate of the ferroelectric field effect transistor 412. Further, the source of the ferroelectric field effect transistor 412 may be electrically connected to an input line of any one of the plurality of input lines IL, and a drain thereof may be electrically connected to an output line of any one of the plurality of output lines OL.

During the learning operation of the neural network device 400, the access transistor 411 is individually turned on through individual word lines WL, and a program pulse may be applied to the gate of the ferroelectric field effect transistor 412 through the bit lines BL. A signal of the training data may be applied through the input line IL. Through this process, weights may be stored in each ferroelectric field effect transistor 412.

During the inference operation of the neural network device 400, all access transistors 411 may be turned on through the entire word lines WL, and a read voltage Vread may be applied through the bit lines BL. Then, the current from synapse devices 410 connected in parallel to the output line OL is added to and flows in each output line OL. An output circuit is connected to the plurality of output lines OL to convert a current flowing through each output line OL into a digital signal.

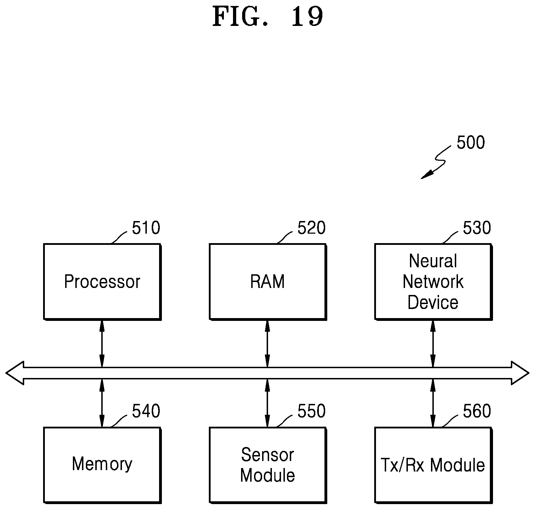

FIG. 19 is a schematic block diagram showing an example configuration of an electronic device including a neural network device. Referring to FIG. 19, the electronic device 500 may analyze input data in real time based on a neural network to extract valid information, determine a situation based on the extracted information, or control configurations of a device equipped with the electronic device 500. For example, the electronic device 500 may be applied to a robot device such as a drone, an advanced driver assistance system (ADAS), or the like, a smart TV, a smartphone, a medical device, a mobile device, an image display device, a measurement device, and an IoT device, and the like, and may be mounted on at least one of various types of devices.

The electronic device 500 may include a processor 510, a random access memory (RAM) 520, a neural network device 530, a memory 540, a sensor module 550, and a communication (Tx/Rx) module 560. The electronic device 500 may further include an input/output module, a security module, a power control device, and the like. Some of the hardware components of the electronic device 500 may be mounted on at least one semiconductor chip.

The processor 510 may be configured to control the overall operation of the electronic device 500. The processor 510 may include a processor core (i.e., Single core) or a plurality of processor cores (i.e., Multi-Core). The processor 510 may process or execute programs and/or data stored in the memory 540. In some embodiments, the processor 510 may control the function of the neural network device 530 by executing programs stored in the memory 540. The processor 510 may be implemented as a central processing unit (CPU), a graphics processing unit (GPU), an application processor (AP), and/or the like.

The RAM 520 may be configured to temporarily store programs, data, or instructions. For example, programs and/or data stored in the memory 540 may be temporarily stored in the RAM 520 according to the control or boot code of the processor 510. The RAM 520 may be implemented as a memory such as dynamic RAM (DRAM), static RAM (SRAM), and/or the like.

The neural network device 530 may be configured to perform an operation of the neural network based on the received input data and generate an information signal based on the execution result. The neural network may include, but is not limited to, convolution neural network (CNN), a recurrent neural network (RNN), a feedforward neural network (FNN), long short-term memory (LSTM), stacked neural network (SNN), state-space dynamic neural network (SSDNN), deep belief networks (DBN), restricted Boltzmann machine (RBM), and/or the like. The neural network device 530 may be a hardware accelerator itself dedicated to a neural network or a device including the same. The neural network device 530 may perform a read or write operation as well as an operation of the neural network. The neural network device 530 may correspond to the neural network device 400 according to the embodiment illustrated in FIG. 18.

The information signal may include one of various types of recognition signals such as a voice recognition signal, an object recognition signal, an image recognition signal, a biometric information recognition signal, and the like. For example, the neural network device 530 may receive frame data included in the video stream as input data and generate, from frame data, a recognition signal for an object included in an image represented by the frame data. However, the neural network device is not limited thereto, and the neural network device 530 may receive various types of input data and generate a recognition signal according to the input data according to the type or function of the device on which the electronic device 500 is mounted.

The neural network device 530 may be configured to perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information or biometric data, advanced driver assistance system (ADAS), voice assistant service, automatic speech recognition (ASR) service, and the like.

The memory 540 may be configured as a storage place for storing data and may be configured to store an operating system (OS), various programs, and various pieces of data. In at least one embodiment, the memory 540 may store intermediate results generated during the operation of the neural network device 530.

The memory 540 may be a DRAM, but is not limited thereto. The memory 540 may include at least one of a volatile memory and a nonvolatile memory. The nonvolatile memory includes read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and the like. The volatile memory includes dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). In at least one embodiment, the memory 540 may include at least one of a hard disk drive (HDD), a solid state drive (SSD), a compact flash (CF), a secure digital (SD), a micro secure digital (Micro-SD), a mini secure digital (Mini-SD), and a memory stick. Additionally, in at least some embodiments, the memory 540 and/or the RAM 520 may include the embodiment illustrated in FIG. 17.

The sensor module 550 may be configured to collect information around a device on which the electronic device 500 is mounted. The sensor module 550 may sense or receive a signal (e.g., an image signal, a voice signal, a magnetic signal, a bio signal, a touch signal, etc.) from the outside of the electronic device 500 and convert the sensed or received signal into data. To this end, the sensor module 550 may include at least one of various types of sensing devices such as a sensing device, for example, a microphone, an imaging device, an image sensor, a light detection and ranging (LIDAR) sensor, an ultrasonic sensor, an infrared sensor, a biosensor, and a touch sensor.

The sensor module 550 may provide the converted data to the neural network device 530 as input data. For example, the sensor module 550 may include an image sensor, generate a video stream by photographing an external environment of the electronic device 500, and sequentially provide the continuous data frame of the video stream to the neural network device 530 as input data. However, embodiments are not limited thereto, and the sensor module 550 may provide various types of data to the neural network device 530.

The communication module 560 may include various wired or wireless interfaces and may be configured to communicate with an external device. For example, the communication module 560 may include a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a communication interface capable of connecting to a mobile cellular network, such as 3rd generation (3G), 4th generation (4G), 5th generation (5G), long term evolution (LTE), and the like.

The ferroelectric field effect transistor, the memory device, and the neural network device described above have been described with reference to the embodiments shown in the drawings. Since the ferroelectric field effect transistor according to the embodiments uses an oxide semiconductor material as a channel, a leakage current is low in an off state and may have a fast operation speed due to high electron mobility of the oxide semiconductor material. In addition, since the ferroelectric field effect transistor according to the embodiments includes a channel intermediate layer with a high oxygen vacancy concentration between the channel layer and the ferroelectric layer, it is possible to enable polarization switching between the two opposite directions of the ferroelectric layer. Accordingly, the memory window of the ferroelectric field effect transistor according to the embodiments may be improved.

In addition, the ferroelectric field effect transistor according to the embodiments may include a gate intermediate layer between the ferroelectric layer and the gate electrode. The gate intermediate layer may increase the memory window by reducing the capacitance between the gate electrode and the ferroelectric layer. In addition, the gate intermediate layer may further increase the memory window by increasing the amount of charge trapped between the gate electrode and the ferroelectric layer.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1.  A ferroelectric field effect transistor comprising:

    a channel layer;
    a gate electrode facing the channel layer;
    a ferroelectric layer between the channel layer and the gate electrode;
    a channel intermediate layer between the channel layer and the ferroelectric layer; and
    a gate intermediate layer between the gate electrode and the ferroelectric layer,

wherein the channel layer and the channel intermediate layer each include an oxide semiconductor material, a concentration of oxygen vacancies in the channel intermediate layer is greater than a concentration of oxygen vacancies in the channel layer,

the gate intermediate layer comprises amorphous silicon oxynitride,

the gate intermediate layer comprises a first surface facing the gate electrode and a second surface facing the ferroelectric layer, and

a concentration of nitrogen in the gate intermediate layer increases from the first surface of the gate intermediate layer toward the second surface of the gate intermediate layer.

2. The ferroelectric field effect transistor of claim 1, wherein the oxide semiconductor material of the channel intermediate layer has a stoichiometrically oxygen-deficient composition.

3. The ferroelectric field effect transistor of claims 1 or 2, wherein a thickness of the channel intermediate layer is less than a thickness of the channel layer;

preferably wherein a sum of the thickness of the channel layer and the thickness of the channel intermediate layer is within a range of 10 nanometers (nm) to 20 nm, and the thickness of the channel intermediate layer is within a range of 1 nm to 5 nm.

4. The ferroelectric field effect transistor of any of claims 1-3, wherein the channel layer comprises a first surface and a second surface facing each other, and the ferroelectric field effect transistor further comprises a source electrode and a drain electrode spaced apart from each other on the first surface of the channel layer.

5. The ferroelectric field effect transistor of claim 4, wherein the gate electrode faces the second surface of the channel layer; or

wherein

the gate electrode faces the first surface of the channel layer, and

the channel intermediate layer is between the source electrode and the drain electrode on the first surface of the channel layer such that the source electrode faces and is spaced apart from a first side surface of the channel intermediate layer and the drain electrode faces and is spaced apart from a second side surface opposite to the first side surface of the channel intermediate layer.

6. The ferroelectric field effect transistor of any of claims 1-5, wherein a thickness of the gate intermediate layer is within a range of 1 nm to 5 nm.

7. The ferroelectric field effect transistor of any of claims 1-6, wherein a concentration of oxygen in the gate intermediate layer decreases from the first surface of the gate intermediate layer toward the second surface of the gate intermediate layer;

preferably wherein a concentration of oxygen on the first surface of the gate intermediate layer is greater at a ratio of 10% or more compared to a concentration of oxygen on the second surface of the gate intermediate layer.

8. The ferroelectric field effect transistor of any of claims 1-7, wherein a concentration of nitrogen on the second surface of the gate intermediate layer is greater at a ratio of 10% or more compared to a concentration of nitrogen on the first surface of the gate intermediate layer; and/or

wherein a concentration of silicon in the gate intermediate layer increases from the first surface of the gate intermediate layer toward the second surface of the gate intermediate layer such that a concentration of silicon on the second surface of the gate intermediate layer is greater at a ratio of 10% or more compared to a concentration of silicon on the first surface of the gate intermediate layer; and/or

wherein a ratio of a silicon concentration to the nitrogen concentration on the first surface of the gate intermediate layer is the same as a ratio of a silicon concentration to the nitrogen concentration on the second surface of the gate intermediate layer.

9. The ferroelectric field effect transistor of any of claims 1-8, wherein

the gate intermediate layer comprises a first gate intermediate layer facing the ferroelectric layer and a second gate intermediate layer between the first gate intermediate layer and the gate electrode,

the first gate intermediate layer comprises at least one of amorphous silicon nitride or amorphous silicon oxynitride, and
the second gate intermediate layer comprises amorphous silicon oxide (SiO).

10. The ferroelectric field effect transistor of claim 9, wherein

the first gate intermediate layer comprises amorphous silicon oxynitride,
the first gate intermediate layer comprises a first surface facing the gate electrode and a second surface facing the ferroelectric layer, and
a concentration of nitrogen in the first gate intermediate layer increases from the first surface of the first gate intermediate layer toward the second surface of the first gate intermediate layer.

11. The ferroelectric field effect transistor of claim 10, wherein a concentration of oxygen in the first gate intermediate layer decreases from the first surface of the first gate intermediate layer toward the second surface of the first gate intermediate layer.

12. The ferroelectric field effect transistor of claim 11, wherein

a concentration of oxygen on the first surface of the first gate intermediate layer is greater at a ratio of 10% or more compared to a concentration of oxygen on the second surface of the first gate intermediate layer, and
a concentration of nitrogen on the second surface of the first gate intermediate layer is greater at a ratio of 10% or more compared to a concentration of nitrogen on the first surface of the first gate intermediate layer.

13. The ferroelectric field effect transistor of claims 11 or 12, wherein

a concentration of silicon in the first gate intermediate layer increases from the first surface of the first gate intermediate layer toward the second surface of the first gate intermediate layer, and
a ratio of a silicon concentration to the nitrogen concentration on the first surface of the first gate intermediate layer is the same as a ratio of a silicon concentration to the nitrogen concentration on the second surface of the first gate intermediate layer.

14. A memory device comprising:

a plurality of gate electrodes and a plurality of spacers alternately stacked in a first direction;
a channel layer spaced apart from the plurality of gate electrodes and the plurality of spacers in a second direction perpendicular to the first direction and extending in the first direction;
a ferroelectric layer between the channel layer and the plurality of gate electrodes and extending in the first direction ;
a channel intermediate layer between the ferroelectric layer and the channel layer and extending in the first direction; and
a gate intermediate layer between the gate electrode and the ferroelectric layer,
wherein the channel layer and the channel intermediate layer each comprise an oxide semiconductor material,
a concentration of oxygen vacancies in the channel intermediate layer is greater than a concentration of oxygen vacancies in the channel layer,
the gate intermediate layer comprises amorphous silicon oxynitride,
the gate intermediate layer comprises a first surface facing the gate electrode and a second surface facing the ferroelectric layer, and
a concentration of nitrogen in the gate intermediate layer increases from the first surface of the gate intermediate layer toward the second surface of the gate intermediate layer.

15. A neural network device comprising

an array of a plurality of synapse devices, wherein
each of the plurality of synapse devices includes an access transistor and the ferroelectric field effect transistor of any of claims 1-13.

# FIG. 1

# FIG. 2

# FIG. 3

oxygen vacancies
concentration

102    104    103

# FIG. 4

increase in
O-deficiency

in intermediate
IGZO

Polarzation
($\mu C/cm^2$)

20

10

0

-10

-20

Gate Voltage (a.u.)

# FIG. 5

Gate Voltage (a.u.)

# FIG. 6

# FIG. 7

# FIG. 8

100b

105
105a
106
106a
103
104
102
107a ⎫ 107
107b ⎭
101

# FIG. 9

200

201
202
206
206a
205
205a
203 204

**FIG. 10**

**FIG. 11**

# FIG. 12

200c

202' {
202a
202b
202a
202b
202a
}
202'

201

207b } 207
207a

205
205a

206
206a

203    204

# FIG. 13

300

304  303  302

A'

305

301

A'

Y

Z  →X

## FIG. 14

## FIG. 15

# FIG. 16

# FIG. 17

# FIG. 18

# FIG. 19

500

| 510 | 520 | 530 |
|---|---|---|
| Processor | RAM | Neural Network Device |

| 540 | 550 | 560 |
|---|---|---|
| Memory | Sensor Module | Tx/Rx Module |

**EP 4 593 549 A1**

Europäisches
Patentamt
European
Patent Office
Office européen
des brevets

# EUROPEAN SEARCH REPORT

Application Number

EP 25 15 1903

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2021/408293 A1 (CHIANG KUO [TW] ET AL) 30 December 2021 (2021-12-30) * paragraph [0073] - paragraph [0107]; figures 23, 24, 25A-25C * | 1-15 | INV. H10B51/30 H10B51/10 H10B51/20 H10D30/67 |
| A | CN 115 732 542 A (TAIWAN SEMICONDUCTOR MFG CO LTD) 3 March 2023 (2023-03-03) * paragraph [0241] * | 1-15 | H10D99/00 H10D30/01 H10D30/69 H10D64/68 |
| A | US 2023/153592 A1 (NAM SEUNGGEOL [KR] ET AL) 18 May 2023 (2023-05-18) * paragraph [0003] - paragraph [0065]; figures 8, 14 * | 1-15 | |

TECHNICAL FIELDS
SEARCHED      (IPC)

H10B
H10D

The present search report has been drawn up for all claims

| Place of search | Date of completion of the search | Examiner |
|---|---|---|
| Munich | 6 June 2025 | Nesso, Stefano |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .......................................................................................

& : member of the same patent family, corresponding document

EPO FORM 1503 03.82 (P04C01)

29

## ANNEX TO THE EUROPEAN SEARCH REPORT
## ON EUROPEAN PATENT APPLICATION NO.

EP 25 15 1903

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2025

| Patent document cited in search report | Publication date | Patent family member(s) | Publication date |
|---|---|---|---|
| US 2021408293 A1 | 30-12-2021 | CN 113540255 A | 22-10-2021 |
| | | DE 102021110533 A1 | 30-12-2021 |
| | | KR 20220001468 A | 05-01-2022 |
| | | TW 202205676 A | 01-02-2022 |
| | | US 2021408293 A1 | 30-12-2021 |
| | | US 2023327024 A1 | 12-10-2023 |
| | | US 2025133774 A1 | 24-04-2025 |
| CN 115732542 A | 03-03-2023 | CN 115732542 A | 03-03-2023 |
| | | TW 202310428 A | 01-03-2023 |
| | | US 11527649 B1 | 13-12-2022 |
| | | US 2023170418 A1 | 01-06-2023 |
| US 2023153592 A1 | 18-05-2023 | CN 116137783 A | 19-05-2023 |
| | | EP 4184511 A1 | 24-05-2023 |
| | | US 2023153592 A1 | 18-05-2023 |

EPO FORM P0459

For more details about this annex : see Official Journal of the European Patent Office, No. 12/82